# EUROPEAN PATENT APPLICATION

(11) **EP 3 522 489 A1**
(43) Date of publication of application: **07.08.2019**
(21) Application number: 19154485.7
(22) Date of filing: 30.01.2019
(51) Int. Cl.: H04L 29/06, H04L 29/08, G06F 11/14

(54) **DYNAMIC DATA COMPRESSION**

(30) Priority: 31.01.2018 US 201815885277
(71) Applicant: Hewlett Packard Enterprise Development LP, Houston, TX 77070 (US)
(72) Inventor: MURALIMANOHAR, Naveen, Palo Alto, CA 94304-1112 (US); XU, Cong, Palo Alto, CA 94304-1112 (US); LESARTRE, Gregg B, Fort Collins, CA 80528-9544 (US)
(74) Representative: Haseltine Lake Kempner LLP

(57) **Abstract**

In some examples, a system performs a dynamic compression adaptation process that includes dynamically adjusting a compression algorithm used for performing data compression, and a location within an arrangement of different types of nodes at which the data compression is performed. Dynamically adjusting the compression algorithm and the location comprises selecting from among a plurality of different compression algorithms and from among locations at different nodes of the different types of nodes based on a state of the arrangement of different types of nodes and a characteristic of a workload for which the data compression is performed.

## Description

### Background

A high performance computer system can include a distributed arrangement of nodes to perform various different tasks. The distributed arrangement of nodes can include a compute node, a memory, and an input/output (I/O) node. The different nodes can communicate with one another over a communication fabric.

Data compression can be performed in the system including the distributed arrangement of nodes to enhance overall system performance. If data is compressed, then the amount of bandwidth of a communication fabric consumed by the compressed data is reduced as compared to the bandwidth consumed when transmitting uncompressed data.

However, compressing data increases processing burden. For example, if a data compression is performed at a compute node, the compute node may become over-burdened if the compute node has to perform other processes for respective programs, including an application, an operating system, and/or a firmware. If the compute node is heavily loaded, then either performance of the data compression or performance of the other processes can suffer.

Moreover, different compression algorithms can achieve different levels of data compression. A first compression algorithm may compress data at a compression factor that is lower than a second compression algorithm-in other words, the first compression algorithm achieves a lower amount of data compression than the second compression algorithm. A "compression factor" can represent or correspond to a ratio uncompressed data to compressed data. The higher the compression factor, the greater amount of compression that is achieved. The tradeoff of the different compression algorithms is that a compression algorithm that can achieve a higher compression factor may consume more processing resources than a compression algorithm that can achieve a lower compression factor. Thus, system performance may be affected by the selection of the compression algorithm to use in compressing data.

### Brief Description of the Drawings

Some implementations of the present disclosure are described with respect to the following figures.
Fig. 1 is a block diagram of a computer system including various nodes according to some examples.
Figs. 2 and 3 are block diagrams of storage media storing machine-readable instructions according to various examples.
Fig. 4 is a block diagram of a system according to some examples.
Fig. 5 is a flow diagram of a process according to further examples.

Throughout the drawings, identical reference numbers designate similar, but not necessarily identical, elements. The figures are not necessarily to scale, and the size of some parts may be exaggerated to more clearly illustrate the example shown. Moreover, the drawings provide examples and/or implementations consistent with the description; however, the description is not limited to the examples and/or implementations provided in the drawings.

### Detailed Description

In accordance with some implementations of the present disclosure, a dynamic compression adaptation system dynamically adjusts a compression algorithm used for performing data compression, and a location within an arrangement of different types of nodes at which the data compression is performed. Dynamically adjusting the compression algorithm and the location includes selecting from among multiple different compression algorithms and from among locations at different nodes of the different types of nodes based on a state of the arrangement of different types of nodes and a characteristic of a workload for which the data compression is performed.

In further examples, the dynamic compression adaptation system is also able to select that compression of a given data be performed at multiple locations using respective different compression algorithms. For example, the dynamic compression adaptation system can decide to apply a lightweight compression algorithm on the given data at a compute node, and then apply a more aggressive compression algorithm at another node, such as at a memory or an I/O node.

In the present disclosure, use of the term "a," "an", or "the" is intended to include the plural forms as well, unless the context clearly indicates otherwise. Also, the term "includes," "including," "comprises," "comprising," "have," or "having" when used in this disclosure specifies the presence of the stated elements, but do not preclude the presence or addition of other elements.

As used here, a "node" can refer to a computer or a collection of computers. Further, a node can also refer to a portion of a computer, such that multiple nodes can be part of one computer.

Different nodes can communicate with one another over a communication fabric. A "communication fabric" can refer to a communication network or multiple communication networks that interconnect(s) various nodes. A communication network can include a wireless network and/or a wired network.

A compute node can include a processor (or multiple processors) to execute machine-readable instructions, such as those of a software application, an operating system, and/or a firmware. A memory can store data in a first level of storage within a hierarchical storage arrangement that has multiple levels of storage. In some examples, a memory can be implemented with any or some combination of the following: a volatile memory device (or multiple volatile memory devices) and a nonvolatile memory device (or multiple nonvolatile memory devices).

An I/O node can include processing capability to control the storage of data in a lower level of storage, which can be implemented with any or some combination of the following: a disk-based storage device (or multiple disk-based storage devices), a solid state storage device (or multiple solid state storage devices), and so forth. The processing capability of the I/O node can include a processor (or multiple processors). A "lower level of storage" refers to a level of storage that can have a larger storage capacity and/or a slower access speed than a higher level of storage, such as a memory. In some cases, data that is more frequently accessed can be stored in the memory so that a data access operation does not have to access the lower level of storage for data found in the memory.

In some examples, the compression of data can be statically defined to be performed at a specific location in a system, and/or the compression algorithm used can be a static compression algorithm that does not change. As workloads change and/or as the state of the system changes, system performance can suffer due to the location at which data compression is performed or the compression algorithm used.

For example, if a compute node is heavily loaded with execution of processes on behalf of programs, then applying the compression at the compute node may reduce overall system performance even though compressed data can more efficiently be communicated over a network, due to the reduced size of the compressed data. More specifically, in some cases, the total amount of time involved in compressing data at a compute node and transmitting the compressed data over a network can exceed the total amount of time of just transmitting uncompressed data over the network. On the other hand, if a compute node is relatively idle, then higher overall system performance can be achieved by compressing data at the compute node before transmitting the data over the network. In a different example, if a compute node is heavily loaded but a node receiving data has ample processing capacity, then it may be more efficient to perform data compression at the receiving node.

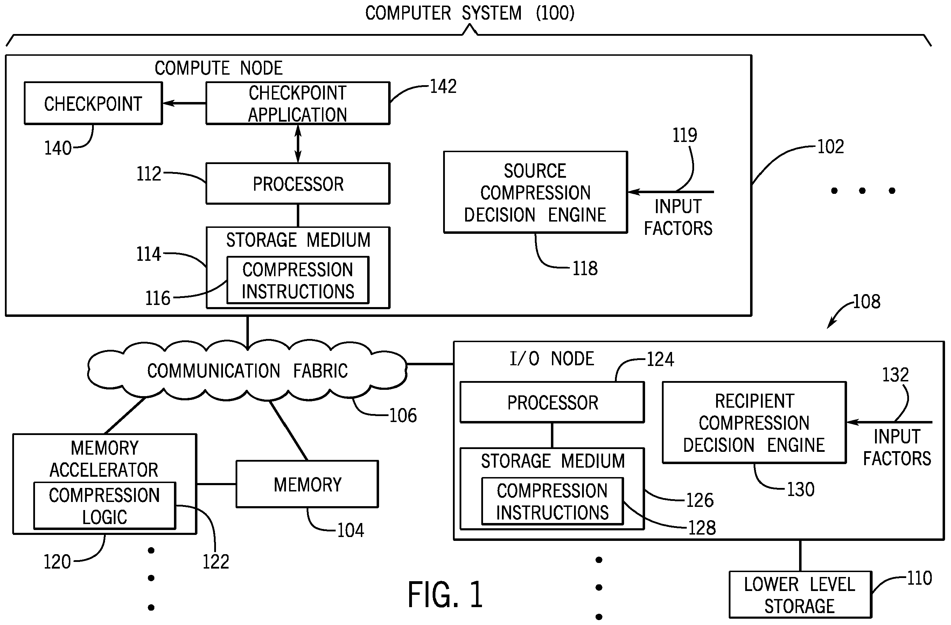

Fig. 1 is a block diagram of an example computer system 100 that includes a compute node 102, a memory 104 coupled to the compute node 102 over a communication fabric 106, and an I/O node 108 that is also coupled to the communication fabric 106. Although specific example nodes are shown in Fig. 1, it is noted that in other examples, a computer system 100 can include other types or arrangements of nodes.

The memory 104 is part of a higher level storage of a hierarchical storage arrangement. Fig. 1 further depicts a lower level storage 110 that is part of another hierarchical level of the hierarchical storage arrangement. Data stored in the lower level storage can be controlled by the I/O node 108. Although just two storage levels are depicted in Fig. 1, it is noted that in other examples, there can be more than two storage levels. The memory 104 is implemented with a storage device, such as a volatile memory device or non-volatile memory device, that has a higher access speed than a storage device used to implement the lower level storage 110.

Although just one compute node 102, one memory 104, and one I/O node 108 are shown in Fig. 1, it is noted that in other examples, there can be more than one compute node 102, and/or more than one memory 104, and/or more than one I/O node 108.

The compute node 102 includes a processor 112 and a storage medium 114 that stores compression instructions 116 that are executable on the processor 112 to compress data when invoked. The invocation of the compression instructions 116 can be dynamically controlled by a source compression decision engine 118. The source compression decision engine 118 can determine, based on input factors 119, whether to invoke the compression instructions 116 at the compute node 102, and if so, the compression algorithm to be applied.

As used here, the term "engine" can refer to a hardware processing circuit, which can include any or some combination of the following: a microprocessor, a core of a multi-core microprocessor, a microcontroller, a programmable integrated circuit device, a programmable gate array, or another type of hardware processing circuit. Alternatively, an "engine" can refer to a combination of a hardware processing circuit and machine-readable instructions executable on the hardware processing circuit.

Although the compute node compression decision engine 118 is depicted in Fig. 1 as being part of the compute node 102, it is noted that in other examples, the compute node compression decision engine 118 can be separate from the compute node 102.

Further, in some examples, multiple source compression decision engines 118 can be associated with respective multiple compute nodes 102, to make respective decisions regarding whether data compressions are to be performed at the corresponding multiple compute nodes 102. Alternatively, one source compression decision engine 118 can be associated with multiple compute nodes 102, and the source compression decision engine 118 can make a decision regarding whether or not to invoke compression instructions 116 at each respective compute node 102 to perform data compression at the respective compute node 102.

The memory 104 is associated with a memory accelerator 120. As used here, a "memory accelerator" (or more simply, an "accelerator") can refer to processing circuitry associated with the memory 104 that can perform data processing tasks associated with data to be stored into or read from the memory 104. For example, the memory accelerator 120 can perform encoding or decoding of data, encrypting or decrypting of data, application of a function to data, and so forth. In accordance with some implementations of the present disclosure, the memory accelerator 120 also includes a compression logic 122 that when invoked can apply compression to data of the memory 104.

The memory accelerator 120 can be a hardware accelerator, or alternatively, can be a combination of a hardware processing circuit and machine-readable instructions. The compression logic 122 of the memory accelerator 120 can be part of the hardware processing circuit of the memory accelerator 120, or can be implemented using machine-readable instructions executed by the memory accelerator 120.

The I/O node 108 includes a processor 124 and a storage medium 126. Compression instructions 128 are stored in the storage medium 126, and can be executed by the processor 124 when invoked.

The invocation of the compression logic 122 in the memory accelerator 120 (and the compression algorithm to be applied by the compression logic 122) or the invocation of the compression instructions 128 in the I/O node 108 (and the compression algorithm to be applied by the compression instructions 128) can be controlled by the recipient data compression decision engine 130 based on input factors 132.

Fig. 1 shows the recipient compression decision engine 130 being part of the I/O node 108. In other examples, the recipient compression decision engine 130 can be separate from the I/O node 108. Also, in some examples, the recipient compression decision engine 130 can make a decision regarding whether to perform data compression at the memory accelerator 120 or at the I/O node 108. In other examples, each of the memory accelerator 120 and the I/O node 108 can be associated with its respective compression decision engine to determine whether the memory accelerator 120 or the I/O node 108 is to compress data received over the communication fabric 106, such as from the compute node 102.

In further examples where there are multiple memory accelerators 120 and/or multiple I/O nodes 108, respective recipient compression decision engines 130 can be associated with the multiple memory accelerators 120 and/or multiple I/O nodes 108. In alternative examples, one recipient compression decision engine 130 can be associated with multiple memory accelerators 120 and/or multiple I/O nodes 108.

In further examples, a given data can be compressed at multiple locations. For example, the source compression decision engine 118 can decide to apply a lightweight compression algorithm on the given data at the compute node 102, and the recipient compression decision engine 130 can decide to apply a more aggressive compression algorithm on the given data.

Fig. 1 shows an example where different compression decision engines (118 and 130) can be distributed across multiple nodes to decide whether to invoke data compression at respective nodes. In accordance with such examples, the data compression decision at the different nodes can be performed in corresponding phases by different compression decision engines.

In alternative examples, the compression decision engines (118 and 130) can be implemented collectively as a central compression decision engine to decide the location of data compression and the compression algorithm to use at the location.

Although Fig. 1 shows one processor 112 or 124 in each compute node 102 or I/O node 108, it is noted that in other examples, the compute node 102 can include multiple processors, and/or the I/O node 108 can include multiple processors. As referred to herein, instructions executable on a processor can refer to the instructions executable on a single processor or executable on multiple processors.

The ensuing discussion refers to the arrangement of Fig. 1 where compression decision engines (118 and 130) are distributed across different parts of the computer system 100. It is noted that techniques or mechanisms according to some implementations are also applicable in computer systems that include a central compression decision engine.

In some examples, data to be compressed in the computer system 100 can include checkpoint data of a checkpoint 140 produced by a checkpoint application 142 executable on the processor 112. A "checkpoint" refers to a snapshot taken of a state of a program (or multiple programs) in the compute node 102, where the state of the program(s) can include data of the program(s) and an operating state(s) of the program(s). In case of failure of the computer system 100 (or a part of the computer system 100), a checkpoint can be used to recover the computer system 100 to a prior known good state.

When multiple checkpoints are taken in a large computer system, the amount of checkpoint data to be stored, such as in the lower level storage 110, can be large. Thus, compression can assist in reducing utilization of processing or communication resources for checkpoint data.

Although examples refer to compressing checkpoint data, it is noted that techniques or mechanisms according to some implementations are applicable to compressing other types of data.

Based on the input factors 119, the source compression decision engine 118 can decide whether to perform data compression at the compute node 102, and if a decision is to perform data compression at the compute node 102, the compression algorithm to use. In some examples, the input factors 119 can include any one or some combination of the following: a workload characteristic, a system state information, and a system configuration information.

The workload characteristic (in the input factors 119) represents a characteristic of the workload, which can include any or some combination of the following: a size of data that is being processed by a workload, a type of the data, such as floating point data, integer data, graphical data, etc.; a type of transaction associated with the workload, such as whether the transaction is a checkpoint transaction for generating a checkpoint, or another type of transaction; and so forth.

The size of the data can indicate how much processing capacity will be consumed in compressing the data, with larger data leading to utilization of higher processing capacity. Also, certain types of data have higher compression factors than other types of data. Also, since checkpoint data is unlikely to be used soon (since it is accessed only when the computer system 100 has experienced a fault and has to recover to a prior state), it may be desirable to compress checkpoint data as early as possible. Data associated with other transactions, such as database transactions, may be accessed in the near future and thus in those cases it may be desirable to store such data in uncompressed form in the memory 104, and only compress when the data is moved to the lower level storage 110.

The system state information (in the input factors 119) can indicate a state of the overall computer system 100 and states of individual components of the computer system. For example, the system state information can include a current loading of each of the compute node 102, memory accelerator 120, and I/O node 108. The system state information can also include information regarding a loading of the communication fabric 106.

For example, for the compute node 102, the system state information can indicate that the compute node 102 is currently executing a process (or multiple processes) for a respective program (or multiple programs), and that the processor(s) 112 of the compute node 102 is (are) currently at some percentage of utilization (or other loading metric). Similar state information can be provided regarding the memory accelerator 120 and the processor(s) 124 of the I/O node 108. For the communication fabric 106, the system state information can include a network load metric that represents an amount of traffic that is currently being communicated over the communication fabric 106 within a given time duration (i.e., a congestion level of the communication fabric 106).

Monitoring agents can be provided throughout the computer system 100, including at the compute node 102, accelerator 120, and I/O node 108, as well as at various communication nodes (such as routers, switches, etc.) of the communication fabric 106 to collect the system state information 132.

The system configuration information (in the input factors 119) can specify a configuration of the computer system 100, including the configuration of each of the compute node 102, memory accelerator 120, and I/O node 108. For example, the system configuration information can include the processing capacity of the processor 112 or 124 (e.g., number of teraflops per second), and the processing capacity of the memory accelerator 120. The system configuration information can indicate that the memory accelerator 120 has a first processing capacity that is lower than the processing capacity of the processor 112 in the compute node 102 or the processor 124 in the I/O node 108. This system configuration information can be used to decide that if it is desired to apply a compression algorithm that achieves a high compression factor, then the data compression should not be performed at the memory accelerator 120 that has a restricted processing capacity. For example, the source compression decision engine 118 can decide that it is more effective to apply the compression algorithm that achieves a high compression factor at the compute node 102.

Although reference is made to the source compression decision engine 118 making its decision based on multiple input factors 119, it is noted that in other examples, the source compression decision engine 118 can make its decision based on just one input factor.

In examples where there are multiple input factors 119, the input factors can be aggregated. For example, if the input factors 119 include a compression factor CF (which represents the amount of compression that can be achieved for a given data) and a network congestion level NL (which represents the loading of the communication fabric 106), the input factors 119 can be aggregated, such as by summing, averaging, or taking some other aggregate of CF and NL. The aggregate score computed based on aggregating CF and NL can then be used to decide whether to perform the data compression at the compute node 102 or at a receiving node (either the memory accelerator 120 or the I/O node 108) after the data has been transmitted in uncompressed form over the communication fabric 106. As a more specific example, if the CF value is high (meaning that the compressibility of the given data is high) and the NL value is high (indicating that the communication fabric 106 is heavily loaded), then the aggregating of the CF value and the NL value will produce a higher aggregate score that would indicate that data compression should be performed at the compute node 102. On the other hand, if the CF value is low and the NL value is low, then that can indicate that it may be more efficient to send the given data in uncompressed form over the communication fabric 106 for compression at the receiving node.

In further examples, the aggregating of the input factors 119 can be a weighted aggregation, such as a weighted average or weighted sum. For example, an aggregate score can be computed by calculating: w1 * CF + w2 * NL, where w1 and w2 are respective weights. There can be more input factors 119 to be included in computing the aggregate score in other examples.

Assuming that the source compression decision engine 118 decided that compression is not to be performed at the compute node 102, the given data may be transmitted in uncompressed form over the communication fabric 106. The uncompressed given data is received by the I/O node 108 (or by the memory 104).

In this phase, the recipient compression decision engine 130 can make a decision, based on the input factors 132, whether to compress the given data at the memory accelerator 120 or at the I/O node 108. In some examples, the input factors 132 can include any one or some combination of the following: a workload characteristic, a system state information, and a system configuration information. The input factors 132 can be aggregated (in similar fashion as the input factors 119) to produce an aggregate score used by the recipient compression decision engine 130 in deciding data compression to be performed at the memory accelerator 120 or the I/O node 108.

More specifically, according to some examples, the workload characteristic can include the size of the data of the workload, the type of the data, and the type of transaction. The system state information can indicate an available space in the memory 104, the processing load of the memory accelerator 120, and the processing load of the I/O node 108.

For example, if the memory 104 has a large amount of available space, then it may make sense to store uncompressed data in the memory 104, and perform data compression at the I/O node 108 when the data is written back to the lower level storage 110. As another example, if the recipient compression decision engine 130 decides that the compression factor of the data is high and it would be more desirable to apply a compression algorithm that achieves a higher compression factor (which would consume more processing resources), the recipient compression decision engine 130 can decide to perform the data compression at the I/O node 108 rather than at the memory accelerator 120. Alternatively, if the recipient compression decision engine 130 determines that the compression factor of the data is low and thus a compression algorithm can be used that achieves a lower compression factor, and the memory accelerator 120 is not heavily loaded with other operations, then the recipient compression decision engine 130 can decide to perform data compression at the memory accelerator 120 rather than at the I/O node 108.

In additional examples, other input factors that can be considered by the source compression decision engine 118 or the recipient compression decision engine 130 can include a factor that indicates whether a workload will use functions of the memory accelerator 120 (such as a memory copy function or a scatter gather function). For a workload that uses functions of the memory accelerator 120, the compression decision engine (118 or 130) may decide to skip data compression, or to apply data compression at the memory accelerator 120.

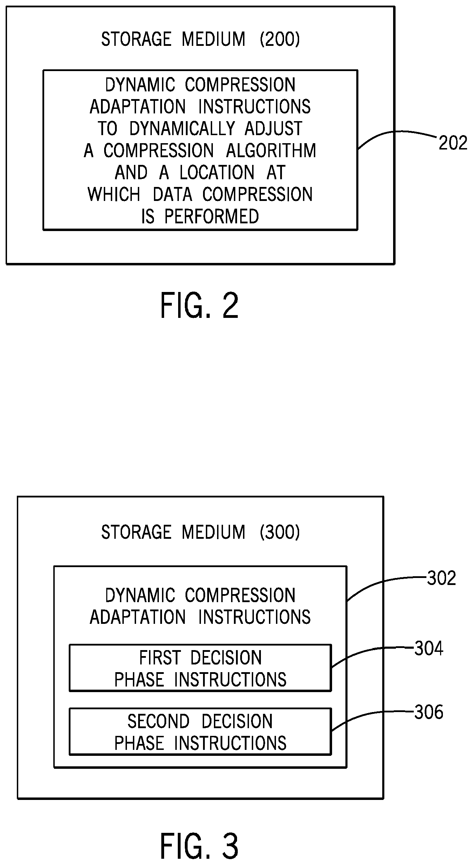

Fig. 2 is a block diagram of a non-transitory machine-readable or computer-readable storage medium 200 storing machine-readable instructions that upon execution cause a system to perform various tasks. The machine-readable instructions include dynamic compression adaptation instructions 202 to perform a dynamic compression adaptation process. The dynamic compression adaptation process includes dynamically adjusting a compression algorithm used for performing data compression, and a location within an arrangement of different types of nodes (such as the nodes 102, 120, and 108 of Fig. 1) at which the data compression is performed. The dynamic compression adaptation instructions can be instructions of the source compression decision engine 118 and/or the recipient compression decision engine 130 of Fig. 1, in some examples.

Dynamically adjusting the compression algorithm and the location by the dynamic compression adaptation process can include selecting from among multiple different compression algorithms and from among locations at different nodes of the different types of nodes based on a state of the arrangement of different types of nodes and a characteristic of a workload for which the data compression is performed.

Fig. 3 is a block diagram of a non-transitory machine-readable or computer-readable storage medium 300 storing dynamic compression adaptation instructions 302 according to further examples for performing a dynamic compression adaptation process for adaptively selecting a compression algorithm and a location of data compression.

The dynamic compression adaptation instructions 302 include first decision phase instructions 304 to, in a first decision phase, decide based on first input factors (e.g., 119 in Fig. 1) whether to perform the data compression at a compute node. For example, the first decision phase instructions 304 can be part of the source compression decision engine 118 of Fig. 1.

The dynamic compression adaptation instructions 302 include second decision phase instructions 306 to perform a second decision phase of the dynamic compression adaptable process. In the second decision phase, in response to the first decision phase deciding to not perform the data compression at the compute node, the second decision phase instructions 306 are to decide based on second input factors (e.g., 132 in Fig. 1) whether to perform, at a receiving node (e.g., the memory accelerator 120 or the I/O node 108), the data compression of uncompressed data transmitted by the compute node over a communication fabric to the receiving node. For example, the second decision phase instructions 306 can be part of the recipient compression decision engine 130 of Fig. 1.

In further examples, the first decision phase instructions 304 can decide to apply a first compression algorithm on a given data at the compute node, and the second decision phase instructions 306 can decide to apply a second compression algorithm (different from the first compression algorithm) on the given data at the receiving node (e.g., the memory accelerator 120 or the I/O node 108).

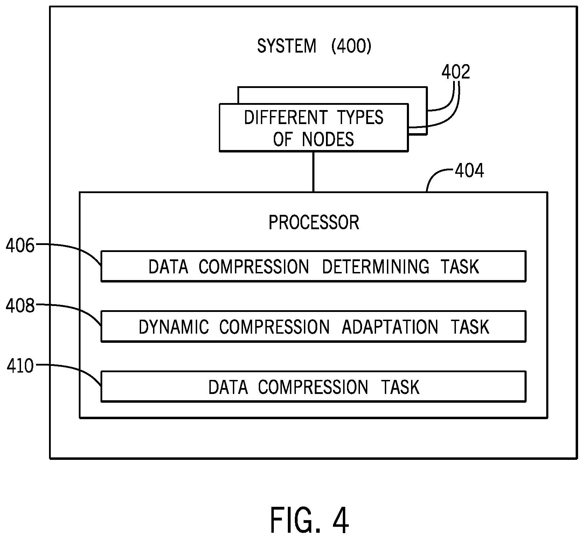

Fig. 4 is a block diagram of a system 400, such as the computer system 100 of Fig. 1. The system 400 includes a plurality of different types of nodes 402 (e.g., the compute node 102, the memory 104, the memory accelerator 120, and the I/O node 108 of Fig. 1). The system 400 further includes a processor (or multiple processors) 404 to perform various tasks. A processor performing a task can refer to a single processor performing the task or multiple processors performing the task. A processor can include a microprocessor, a core of a multi-core microprocessor, a microcontroller, a programmable integrated circuit, a programmable gate array, or another hardware processing circuit.

The tasks performed by the processor 404 include a data compression determining task 406 to determine that data compression of data of a workload is to be performed. The tasks further include a dynamic compression adaptation task 408 to, for performing the data compression, dynamically select a compression algorithm from among a plurality of different compression algorithms, and a location from among the plurality of different types of nodes, based on a state of the system and a characteristic of the workload. The tasks further include a data compression task 410 to perform the data compression of the data of the workload using the selected compression algorithm and at the selected location.

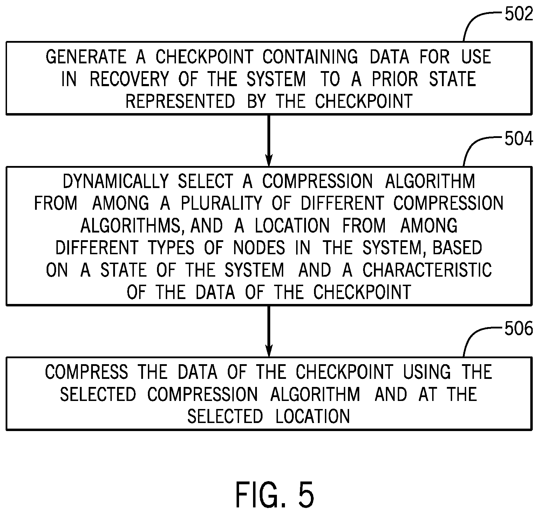

Fig. 5 is a flow diagram of a process according to further examples, which can be performed in the computer system 100 of Fig. 1, for example. The process generates (at 502) a checkpoint containing data for use in recovery of the computer system to a prior state represented by the checkpoint. The process further dynamically selects (at 504) a compression algorithm from among a plurality of different compression algorithms, and a location from among a different types of nodes in the system, based on a state of the system and a characteristic of the data of the checkpoint. The process further compresses (at 506) the data of the checkpoint using the selected compression algorithm and at the selected location.

The storage medium 200 (Fig. 2) or 300 (Fig. 3) can include any or some combination of the following: a semiconductor memory device such as a dynamic or static random access memory (a DRAM or SRAM), an erasable and programmable read-only memory (EPROM), an electrically erasable and programmable read-only memory (EEPROM) and flash memory; a magnetic disk such as a fixed, floppy and removable disk; another magnetic medium including tape; an optical medium such as a compact disk (CD) or a digital video disk (DVD); or another type of storage device. Note that the instructions discussed above can be provided on one computer-readable or machine-readable storage medium, or alternatively, can be provided on multiple computer-readable or machine-readable storage media distributed in a large system having possibly plural nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In the foregoing description, numerous details are set forth to provide an understanding of the subject disclosed herein. However, implementations may be practiced without some of these details. Other implementations may include modifications and variations from the details discussed above. It is intended that the appended claims cover such modifications and variations.

## Claims

1. A non-transitory machine-readable storage medium storing instructions that upon execution cause a system to:
perform a dynamic compression adaptation process comprising dynamically adjusting a compression algorithm used for performing data compression, and a location within an arrangement of different types of nodes at which the data compression is performed,
wherein dynamically adjusting the compression algorithm and the location comprises selecting from among a plurality of different compression algorithms and from among locations at different nodes of the different types of nodes based on a state of the arrangement of different types of nodes and a characteristic of a workload for which the data compression is performed.

2. The non-transitory machine-readable storage medium of claim 1, wherein the different types of nodes comprise a compute node and a receiving node coupled over a communication fabric to the compute node, and wherein the selecting from among the locations comprises selecting from among the compute node and the receiving node to perform the data compression.

3. The non-transitory machine-readable storage medium of claim 2, wherein the receiving node comprises a memory or an input/output (I/O) node that is coupled to a lower level storage, wherein, optionally, selecting the memory to perform the data compression comprises selecting an accelerator associated with the memory to perform the data compression.

4. The non-transitory machine-readable storage medium of claim 2, wherein the dynamic compression adaptation process comprises:
in a first decision phase, decide whether to perform the data compression at the compute node; and
in response to the first decision phase deciding to not perform the data compression at the compute node, decide, in a second decision phase, whether to perform, at the receiving node, the data compression of uncompressed data transmitted by the compute node over a communication fabric.

5. The non-transitory machine-readable storage medium of claim 4, wherein the first decision phase uses first input factors, and the second decision phase uses second input factors wherein, optionally, the first decision phase aggregates the first input factors and makes a data compression decision based on the aggregating of the first input factors, and the second decision phase aggregates the second input factors and makes a data compression decision based on the aggregating of the second input factors.

6. The non-transitory machine-readable storage medium of claim 1, wherein the dynamic compression adaptation process applies a first compression algorithm on a given data at a first node of the different types of nodes, and applies a different second compression algorithm on the given data at a second node of the different types of nodes.

7. The non-transitory machine-readable storage medium of claim 1, wherein selecting from among the locations at different nodes based on the characteristic of the workload comprises selecting from among the locations at different nodes based on a compression factor of data of the workload.

8. The non-transitory machine-readable storage medium of claim 1, wherein selecting from among the locations at different nodes based on the state of the arrangement of the different types of nodes comprises:
(i) selecting from among the locations at different nodes based on a congestion level of a communication fabric that interconnects nodes in the arrangement of the different types of nodes; or
(ii) selecting from among the locations at different nodes based on processing utilizations at respective nodes in the arrangement of the different types of nodes.

9. The non-transitory machine-readable storage medium of claim 1, wherein selecting from among the plurality of different compression algorithms comprises selecting from among a first compression algorithm and a second compression algorithm that achieves a lower amount of compression than the first compression algorithm; and, optionally, selecting the first compression algorithm in response to selecting a memory accelerator associated with a memory to perform the data compression and selecting the second compression algorithm in response to selecting an input/output (I/O) node to perform the data compression.

10. The non-transitory machine-readable storage medium of claim 1, wherein selecting from among the locations at different nodes comprises:
(i) selecting an I/O node to perform the data compression in response to determining that data is to be stored in a lower level storage; or
(ii) selecting a memory accelerator associated with a memory to perform the data compression in response to a determination that the workload is to use the memory accelerator to perform an operation of the workload.

11. A system comprising:
a plurality of different types of nodes; and
a processor to:
determine that data compression of data of a workload is to be performed,
dynamically select a compression algorithm from among a plurality of different compression algorithms, and a location from among the plurality of different types of nodes, based on a state of the system and a characteristic of the workload, and
perform the data compression of the data of the workload using the selected compression algorithm and at the selected location.

12. The system of claim 11, wherein to dynamically select the compression algorithm and the location is performed in a plurality of decision phases that consider respective input factors, a first decision phase of the plurality of decision phases to decide whether to perform data compression at a compute node, and a second decision phase of the plurality of decision phases to decide whether to perform data compression at a receiving node that receives uncompressed data from the compute node.

13. The system of claim 11, wherein the data of the workload comprises checkpoint data for a checkpoint generated by the system.

14. A method comprising:
generating, by a system comprising a processor, a checkpoint containing data for use in recovery of the system to a prior state represented by the checkpoint;
dynamically selecting, by the system, a compression algorithm from among a plurality of different compression algorithms, and a location from among different types of nodes in the system, based on a state of the system and a characteristic of the data of the checkpoint; and
compressing, by the system, the data of the checkpoint using the selected compression algorithm and at the selected location.

15. The method of claim 14, wherein dynamically selecting from among the different types of nodes to perform the compressing of the data of the checkpoint comprises selecting from among a compute node, a memory, and an input/output (I/O) node.
